# EUROPEAN PATENT SPECIFICATION

(11) **EP 0 318 624 B1**
(45) Date of publication and mention of the grant of the patent: **10.11.1993**
(21) Application number: 87480020.4
(22) Date of filing: 01.12.1987
(51) Int. Cl.: H03K 19/094

(54) **Multibase bi-CMOS logic circuit family**
Logische Schaltkreisfamilie von Multibasis-bi-CMOS
Famille de circuits logiques bipolaire-CMOS multibase

(43) Date of publication of application: 07.06.1989
(73) Proprietor: International Business Machines Corporation, Armonk, N.Y. 10504 (US)
(72) Inventor: Boudon, Gérard, F-91540 Mennecy (FR); Ong, Ieng, F-92160 Antony (FR); Mollier, Pierre, F-77310 Boissise le Roi (FR)
(74) Representative: Klein, Daniel Jacques Henri

(56) References cited:
- EP-A- 0 101 896
- ELECTRONICS, 10th July 1986, pages 67-70, New York, US; "How motorola moved BIMOS up to VSLI levels"
- IEE 5TH EUROPEAN SOLID STATE CIRUCITS CONFERENCE - ESSCIRC 79, London, 18th-21st September 1979, pages 155-157; L. SPAANENBURG et al.: "Bigfet logic"
- PATENT ABSTRACTS OF JAPAN, vol. 11, no. 292 (E-543)[2739], 19th September 1987; & JP-A-62 90 030 (NEC CORP.) 24-04-1987
- PATENT ABSTRACTS OF JAPAN, vol. 9, no. 185, (E-332)[1908], 31st July 1985; & JP-A-60 55 726 (HITACHI SEISAKUSHO K.K.) 01-04-1985

## Description

The present invention relates in general to Bi-CMOS logic circuits (bipolar and CMOS circuitry on the same chip), and more particularly to a new family of logic circuits with improved power delay product while still maintaining the low power dissipation, high input impedance and high noise immunity of the CMOS devices on the one hand, and the high drive capabilities of the bipolar devices on the other hand.

Several Bi-CMOS circuits have been described in the literature. All these circuits work on the same principle: bipolar transistors operate as a push-pull current booster, while Field Effect Transistors (NFET's and PFET's) are used to provide logic functions and to drive the base current of the said bipolar transistors. In others words, in an optimized circuit designed to get the best use of both bipolar and unipolar technologies, FET's are used for logic implementation, and bipolar transistors for load driving.

Examples of such optimized circuits known to the applicant to date, are given in the following references:
Ref. 1: How Motorola moved BIMOS up to VLSI levels, Electronics, July 10, 1986, pp 67-70.
Ref. 2: CMOS/Bipolar Circuits for 60 MHz Digital Processing by T. Hotta et al, IEEE Journal of SSC, Vol. SC-21 No.5, October 1986, pp 808-813.
Ref. 3: A subnanosecond Bi-CMOS gate array family by H. Nakashiba et al, IEEE 1986, Custom Integrated Circuits Conference, pp 63-66.

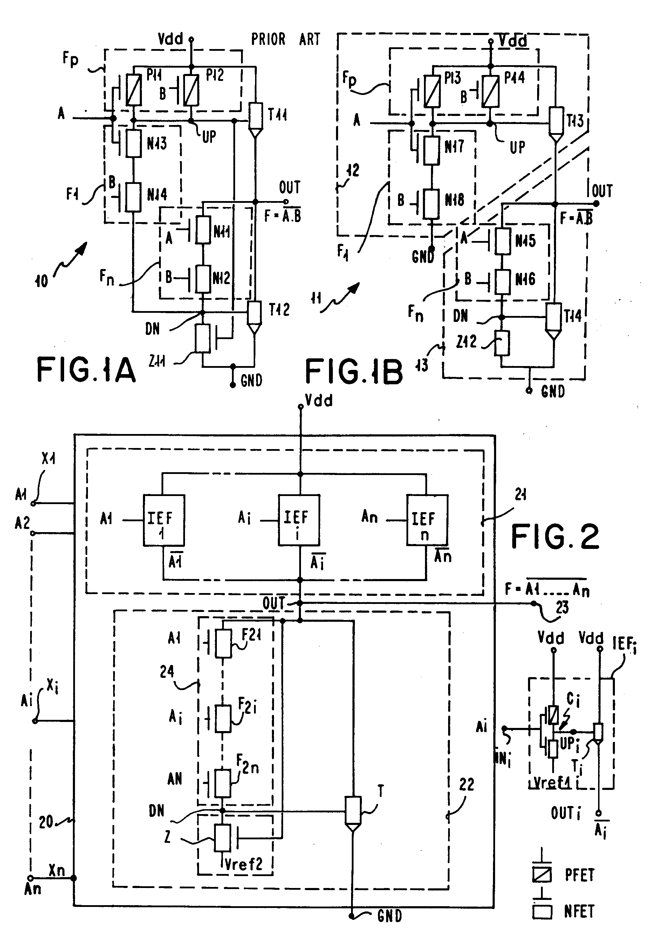

Figs.1A and 1B of the present application depict two known Bi-CMOS NAND gate circuits as published in references 1 and 2 respectively.

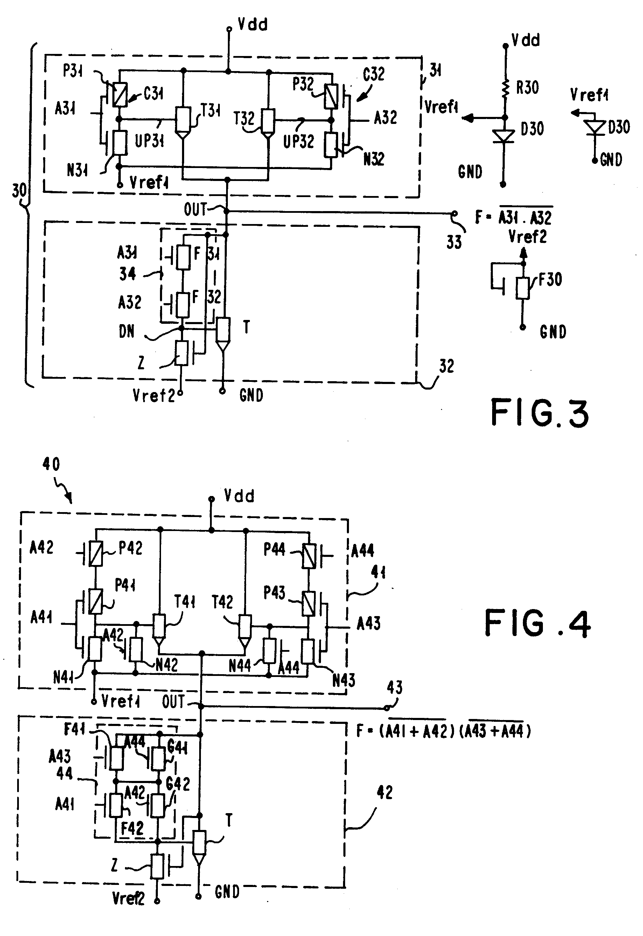

Fig. 1A shows a standard implementation of a two input Bi-CMOS NAND gate circuit referenced 10, with FET and bipolar devices, as illustrated in Fig. 3 of Ref. 1.

From Fig. 1A, it may be understood that the logic block Fp is built with PFET'S P11 and P12 while its dual block Fn is built with NFET'S N11 and N12. Fp and Fn provide the base current to NPN transistors T11 and T12 respectively when these transistors are turned on. T11 and T12 are the pull-up and the pull-down transistors respectively of the gate circuit, and act as the driving devices for the next stages. The common node between emitter of T11 and collector of T12 is the output node referenced OUT and is connected to the output terminal where the logic function F performed by the gate circuit is available.

To cut off T11, electric charges stored at the node UP must be discharged. This discharge is controlled by the logic block F1 comprised of NFET'S N13 and N14, similar to Fn. However, it is to be noted, that the discharge can also be done through a resistor (such as referenced Z in Fig. 2 of Ref. 2).

For the same reason, to cut off T12, node DN is discharged by a discharge device Z11 such as a feedback NFET, the gate of which is tied to the UP node (it might be connected to the OUT node as well). Node DN might also be discharged by a resistor (such as referenced Z in Fig. 2 of Ref. 2).

The logical operation of the NAND gate circuit shown in Fig. 1A may be explained as follows:
When input A or B (or both) is "low" ('0' logic), the node UP is set at the same voltage as Vdd by PFETS, T11 is turned on, while T12 is cut off because of the "off" state of the two NFETS, so that output OUT is set to "high" ('1' logic).

When inputs A and B are both "high", none of the PFETs conducts, T11 is off, while T12 is turned on by the NFETS. Output OUT is set to "low".

Now, let input A (or B) go from "high" to "low", the other one staying "high", one of the PFETS P11 (or P12) will turn on T11, while T12 base is no longer biased, because N11 (or N12) is set to off state. Therefore, the output will go from "low" to "high". Therefore, the logic function 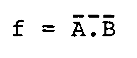
is available at output OUT.

Fig. 1B shows another embodiment of a two input Bi-CMOS NAND gate circuit similar to the one shown in Fig. 2a of Ref. 2. The circuit of Fig. 1B referenced 11 has some similitudes with circuit 10 of Fig. 1A, however logic block F1 comprised of NFET'S N17 and N18 is now connected to the ground instead of the DN node, and the discharge device Z12 now consists of a resistor.

The capacitive load at the output node OUT is charged up or discharged with the NPN transistors T13 or T14 respectively. In short, the NPN transistors operate as a set of current booster. In this circuit, the electric charges stored at the base nodes UP and DN flow out through the F1 block comprised of N17 and N18 and the resistor Z12 respectively. This discharge contributes to speed-up and power-reduction by minimizing the time when the both NPN transistors are active. The logic operation is quite the same as explained above.

What is interesting from that figure is that the two input Bi-CMOS NAND circuit of Fig. 1B may be understood as being comprised of both a pull up block 12 and a pull down block 13.

The pull down block 13 is comprised of N15, N16 and T14, whilst the pull up block 12 is comprised of N17, N18, P13, P14 and T13. These blocks are coupled in one point which is the output node OUT connected to the output terminal where the logic function F is available.

In both cases shown in Figs. 1A and 1B, a Bi-CMOS NAND gate circuit has been chosen for sake of simplicity. It exhibits high performance, low power consumption, and ease of configuration. According to the basic philosophy of the Bi-CMOS technology, the circuit uses a pair of push-pull bipolar devices to provide the needed driving capability, while the low power requirements of CMOS are preserved because the circuit draws no D.C. current. These characteristics allow any CMOS circuit to be modified into a Bi-CMOS structure. The bipolar push-pull devices isolate the CMOS circuits from the loading, so the unit load degradation is the same for all circuit functions. In addition, dissipation is lower than in an equivalent bipolar circuit, and average dissipation is even less than in an equivalent CMOS circuit.

One of the problems caused by this kind of circuits remains its relatively slow rising and falling signals at node UP, due to the use of heavily loaded FETS (one PFET and one NFET per logic input) connected to the pull up transistor in the emitter follower. When several inputs are used, the logic function that drives node UP is performed by several CMOS devices. For instance, the Fp and Fn blocks of a 4 way Nand would be composed of 4 PFET'S in parallel and 4 NFET'S in series. It is well known that such a CMOS logic circuit has low rise and fall transitions: the greater the number of inputs, the slower the transitions. In addition to impacting propagation delay, the increase of transition time when both NPN transistors are turned on, causes a crossover current which flows from Vdd to ground through said NPN transistors, thus power consumption increases. This phenomenon becomes even crucial with submicron devices.

It is therefore, a primary object of the present invention to provide a new family of Bi-CMOS logic circuits, the speed performance of which, does not degrade when the number of logic inputs increases.

It is still another object of the present invention to provide a new family of Bi-CMOS logic circuits with quick charge or discharge at the UP node, to improve speed and reduce power consumption by minimizing the time when both NPN transistors are active.

It is still another object of the present invention to provide a new family of Bi-CMOS logic circuits having reduced cross over currents when both NPN transistors are active.

In carrying out the above and other objects of the main embodiment of the present invention, there is provided a new family of n input Bi-CMOS logic circuits comprising a pull up block and a pull down block having an output node coupled therebetween. According to the present invention, the pull up block is comprised of n basic cells; each cell being implemented with a determining logic circuit driving a NPN pull up transistor mounted as an emitter follower. Each determining logic circuit is biased between a first power voltage (Vdd) and a first reference voltage (Vref1). Logic inputs or signals A1 to Ap (p may be different or equal to n) are applied to the inputs of the determining logic circuits. Emitters of all NPN pull up transistors are tied altogether to provide an OR dotting and connected to said output node where the logic function F is available. This particular implementation is the main feature of the present invention.

In a particular implementation, said determining logic circuit consists of a CMOS inverter.

As a result, the circuit which drives the NPN pull up transistor of the pull up block is no longer a slow CMOS logic functional circuit as practiced in the prior art. It has been replaced by fast CMOS inverters followed by fast bipolar transistors or circuits. In others words, the single big NPN pull up transistor of the prior art has been replaced by a plurality of small NPN transistors, having separate base regions. This means that the base of each NPN transistor may be individually driven. The circuit family which is derived therefrom, is therefore called MULTIBASE. Lighly loaded CMOS inverters are faster than complex CMOS logic circuits and the delay added due to bipolar OR dotting is negligeable in this push-pull configuration.

In another particular implementation said determining logic circuit is selected among elementary logic functional circuits such as NOR, NAND, ... etc.

The pull down block is comprised of n NFETS, each receiving a logic input and being connected serially to form a stack mounted between a first and a second node. Said first node is connected to a discharge device (such as a NFET biased at a second reference voltage : Vref2) and to the base of a NPN pull down transistor. The collector of the NPN pull down transistor and the other node of the NFET stack are tied altogether and connected to the output terminal OUT. The emitter of the said NPN pull down transistor is biaised at a second power voltage: the ground GND. This implementation is standard, however, according to still another embodiment of the present invention, several pull down blocks may be paralleled.

Figs. 1A and 1B show schematics of known implementations, of a two-input NAND gate circuit of the prior art in Bi-CMOS technology.

Fig. 2 shows the block diagram of a n input NAND bi-CMOS circuit to illustrate a preferred embodiment of the present invention.

Fig. 3 shows the actual implementation of a two input Bi-CMOS NAND circuit featuring a Multi Base structure according to said preferred embodiment of Fig. 2 for improved speed performance and reduced power consumption.

Fig. 4 shows the implementation of a 2 x 2 input Multi Base Bi-CMOS OAI circuit.

Fig. 5 and 6 respectively show the implementation of a Multi Base XOR and a high density Multi Base 4 input NAND Bi-CMOS circuit.

Fig. 7 shows the implementation of a high speed Multi Base 4 input NAND circuit with a duplicated pull down block according to another embodiment of the present invention.

Fig. 8 shows a comparison of the cross over current, between the circuits of the prior art such as depicted in Figs. 1A and 1B and the circuit of the present invention shown in Fig. 3.

The basic principle of the present invention may be understood from the following study, which is given with respect to a n input NAND gate circuit, only for illustrating a preferred embodiment of the present invention.

Let us consider an n input (A1, ..., An) NAND gate circuit and its related logic function F.

$\text{F =} \overline{\text{A1 x A2 x ...Ai x ...An}} \text{(1)}$

or written differently

$\text{F =} \overline{\text{A1}} \text{+} \overline{\text{A2}} \text{+ ...} \overline{\text{Ai}} \text{+ ...} \overline{\text{An}} \text{(2)}$

To implement such a function in BiCMOS circuitry, we can imagine to use equation (2) to build the pull-up block Of the n input NAND gate circuit according to the following scheme: each cell is implemented with a CMOS inverter driving a NPN transistor. These 3 devices form a basic cell named "Inverted Emitter Follower" or IEF and may be symbolically represented by IEF=INVERT.EF to express that the basic IEF cell is constituted by an inverter driving an emitter follower. A logic input signal Ai applied on the circuit of cell IEFi, is therefore inverted, and the logic signal 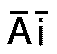 is available at the output of the cell.

The pull-up block could be built by connecting all these IEF cells to perform an "OR" function, between the logic outputs, thus performing the resulting logic function 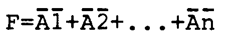
or

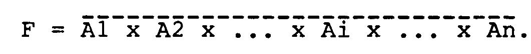

One can also imagine to build the pull-down block according to equation (1): n NFETs are connected serially to drive a single NPN transistor. More generally, the circuit in the pull down block is the dual image of the logic circuit in the pull up block, as it is well known for the man skilled in the art.

Fig. 2 shows the block diagram of such an n input NAND circuit implemented according to said preferred embodiment of the invention as explained above. The n input NAND circuit 20 is implemented by connecting in series the pull-up and pull-down blocks, respectively referenced 21 and 22, between a first power (voltage) supply (e.g. Vdd) and a second power (voltage) supply (e.g. the ground GND). The common node at point of coupling, is the output node OUT of the circuit. Therefore, logic function F is available at the output node terminal referenced 23. Logic input signals A1, ..., An are respectively applied to input terminals X1, ..., Xn of circuit 20, then to appropriate input terminals of appropriate P and N type devices.

According to the basic principle of the present invention, pull up block 21 is comprised of n basic cells referenced IEF1 to IEFn. Each cell IEFi (i= 1 to n) is comprised of a CMOS inverter Ci (formed of a pair of complementary FETS) driving a NPN pull up transistor Ti. The drain region of the PFET and the collector of Ti are connected to Vdd. The node which is common between the output of the inverter Ci and the base of the NPN transistor is referenced as the UPi node. The logic signal Ai is applied to the input terminal INi of the inverter Ci. Each logic signal Ai is inverted to control the base of transistor Ti, which is mounted in an emitter follower configuration. The terminal which corresponds to the emitter of Ti, and where A̅i is available, is referred to as OUTi. The source region of the NFET of the CMOS inverter Ci can be grounded or connected to a reference voltage Vref1i. In most, if not all applications, all these reference voltages Vref1i (i = 1 to n) will be identical and equal to Vref1. Vref1 must be selected according to the following relation:

${\text{Ground ≦ Vref1 < Ground + 2 V}}_{\text{BE}} \text{(Ti)}$

V_{BE}(Ti) means the potential difference between the base and emitter of transistor Ti. As clear from Fig. 2, all emitters of transistors Ti are tied together to perform an OR dotting, and connected to the output node OUT of the circuit. It is a main characteristic of the circuit of present invention to result in a Multi Base structure with dotted emitters.

The pull down block 22 is comprised of n NFETS F21 to F2n serially connected between a first and a second node to drive a single NPN pull down transistor T. These n NFETs form a logic stack referenced 24 which is the complementary image of the circuit in the pull up block. In addition, conduction of the logic stack is controlled by a discharge device Z connected to a second reference voltage Vref2. In a preferred embodiment said discharge device Z is a NFET gate electrode of which is connected to the output node and its source region to ground or to a second reference voltage Vref2 such as:

${\text{Ground ≦ Vref2 < Ground + V}}_{\text{BE}} \text{(T)}$

The first node, which is common between the logic stack (source region of F2n), the base of the NPN transistor T and the drain region of the discharge NFET Z, is referenced DOWN node or DN.

The second node of the stack (drain region of F21) is tied with the collector of T and connected to the output node OUT.

As a main result, the circuit which drives the pull up block is no longer a slow CMOS logic functional circuit, it has been replaced by fast CMOS inverters followed by fast bipolar transistors or circuits. Lightly loaded CMOS inverters are faster than complex CMOS logic circuits and the delay added due to bipolar OR dotting is negligeable in this push-pull configuration.

As an example of that preferred embodiment shown in Fig. 2, Fig. 3 shows the actual implementation of a two input Multi Base NAND, referenced 30 so called hereafter a MBNAND. The pull-up block 31 of the MENAND is comprised of 2 IEF cells implemented with 2 CMOS inverters C31 (P31, N31) and C32 (P32, N32) driving respectively two NPN transistor T31 and T32. In the pull up block, the reference voltage generator to supply Vref1 is implemented with either a diode D30 or the combination of a resistor R30 and a diode D30. In the pull down block, Vref2 is implemented with a reference voltage generator consisting of a low threshold NFET F30. In certain logic configuration, T31 (or T32 or both) may have its base-emitter junction biased in reverse, which in turn may result in reliability problems. The role of diode D30, that can be combined with the high value resistor R30, is to decrease the reverse voltage and to maintain one V_{BE} on the base of T31, while the emitter of the latter is maintained by T32 at one V_{BE} below the power supply Vdd. For this reason this circuit operates at low power supply (e.g. 3.3 V) as defined by the new generation of CMOS circuits.

The pull down block 32 including its logic stack referenced 34 is identical to pull down block 24 of Fig. 2.

When both input signals A31 and A32 are "high", the output is "low" with F31, F32 and T conducting. T31 and T32 are off with their bases biased near ground at one V_{BE}.

When either input A31 (or A32) is low, the output is high with T31 (or T32) conducting, while T is off with its base biased at the threshold of N FET Z (e.g. 0,5 V). When both inputs are "low", the output is "high" with T31, T32 conducting, while T is off with its base biased at the threshold of Z.

When an input A31 (or A32) is "high", and the other A32 (or A31) switches from high to "low", T31 (or T32) remains off, T32 (or T31) will be turned on with its base biased to Vdd, while T will be cut off. Thus, the output goes from "low" to "high" to perform the NAND function. In this configuration, T31 has its base emitter junction in reverse.

As the parasitic capacitances on nodes UP31 and UP32 are reduced, rising and falling signal at nodes UP31 and UP32 of circuit 30 are faster than those observed for state of the art circuits.

Output rise delay is reduced because each PFET (e.g. P31, ...) has to drive very small capacitance, when the signal goes from "low" to "high" at UP31 (or UP32).

Output signal fall delay is also reduced, as electric charges become fewer with small capacitances at node UP31 (or UP32) and flows out rapidly through only one FET N31 (or N32) when the output signal goes "high" to "low". As a result, transition time is cut down, as well as the cross-over current, so that the output signal goes very rapidly from "high" to "low".

The diminution of cross-over current reduces drastically the power consumption as it will be shown later.

Voltage references Vref1 and Vref2 permit to reduce the signal swing at nodes UP (UP31, UP32) and DOWN (DN), and therefore contributes to significantly improve switching speed at these nodes, which in turn, results in better circuit performance.

The input capacitance of the circuit is also reduced, because smaller NFETs and PFETS are required to drive the pull-up NPN transistors (T31, ...). This also contributes to improve the global performance of the circuit.

This kind of new circuits featuring a Multi Base structure, offers several additional advantages.

It is very easy to extend the number of logic inputs of the present circuit to implement 3, 4, 5... etc input MBNAND. In addition, the delay increase due to the input count is much lower, thanks to the use of the 2 emitter followers connected in parallel in the pull up block compared with conventional schemes.

For example, according to our simulations and for a given process, a 4 input NAND circuit in accordance with the invention, is 2 times faster than a traditional one, and power consumption is cut down by a factor of 4.

Although the NAND function fits very well with the Multibase concept, others and more complex functions, can be implemented with the same concept. In others words, the basic principle of implementing a Multi Base structure as depicted above with respect to Fig. 2 and 3, may be easily generalized to create an extended family of different logic circuits still based on the Multi Base concept. For example, the basic IEF cell may be modified in different ways to provide other logic functions. This may be simply achieved by replacing the CMOS inverter by logic gates such as NAND, NOR, ... etc. Generalizing the basic principle as explained with respect to Fig. 2 and 3, implies that the logic circuit which drives each NPN pull up transistor Ti may have other function than INVERT. The CMOS logic circuit which drives Ti is so called "a determining logic circuit" thereafter. In these implementations, the number of cells may be different than the number of inputs. In addition, the logic stack may also be provided with more complex arrangement, so that either independently or in combination with a modified pull up block, it provides different and more complex logic functions.

Let us consider above equations (1) and (2). If each input Ai represents a m input OR function, F becomes an nxm input OR-AND-INVERT (OAI) function. This allows generalization of the basic principle which is illustrated in Figs. 2 and 3.

Fig. 4 shows a 2x2 input Multi-Base OAI circuit according to another embodiment of the present invention. Now turning Fig. 4, there is shown an OAI circuit 40, wherein in the pull up block 41, the basic IEF cells have been made a little bit more complex, by performing a NOR function, and not only an INVERT function. In other words, using the same symbolic wording as that above, this can be expressed by IEF=NOR.EF. All the logic output such as 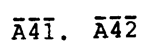
are OR dotted at the output node OUT to provide logic function 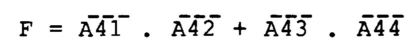
on the output terminal 43. The logic stack 44 in the pull down block 42, is modified to have the appropriate serial/parallel connection. The propagation delays of this circuit are equivalent to those of two input NOR and two input HAND circuits serially connected.

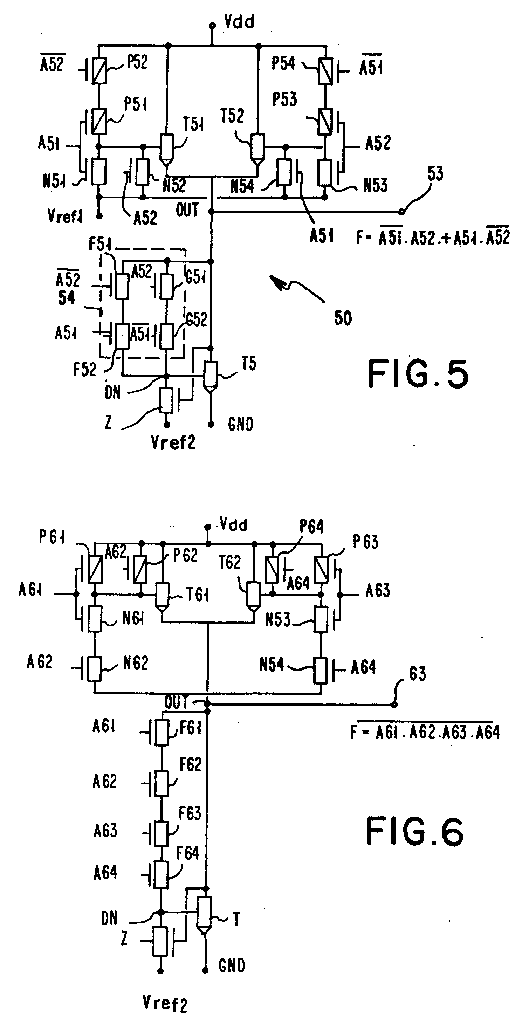

Fig. 5 shows an Multi-Base XOR circuit where complementary logic inputs 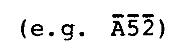
are provided by additional CMOS inverters (not represented). The same principles as explained above with respect to the embodiment of figure 4, are used again in the circuit 50 of Fig. 5, except in the logic stack 54. A parallel connection is completed to perform the desired function. In the present case IEF = NAND.EF (F51 and F52 in parallel with G51 and G52). This allows to perform a XOR function so that 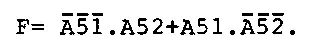
The propagation delays of this circuit are equivalent to those of a two input OR-AND circuit and a two input NAND circuit serially connected.

Still using the same concept as described above with respect to Multi-Base circuits implementing more complex functions, a high density version of Multi-Base NAND circuit may be derivated. If very high speed is not required, a n input NAND circuit can be built with n/2 emitter followers, by considering each input signal Ai of equations (1) and (2) as an two input NAND. Fig. 6 shows a schematic of such a high density Multi-Emitter 4 input NAND circuit. It is to be noted that, in the circuit of Fig. 6, the number of input signals, say 4 is different from the number of Inverted Emitter Follower (IEF) cells: say 2.

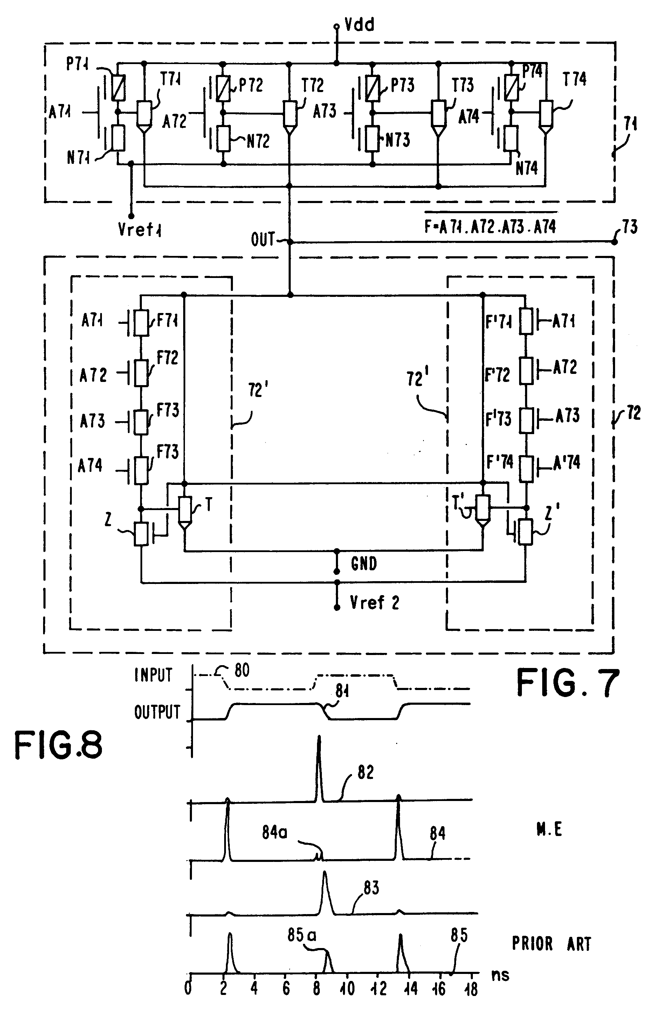

When several NFETs stacks are paralleled (more than 4) in the pull-down block, fall delay may be impacted. According to another embodiment of the present invention, two (or more) pull-down blocks can be paralleled as shown in Fig. 7, to reduce the fall delay.

Fig. 7 shows a 4 input NAND gate circuit 70 performing the logic function 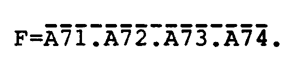
The pull up block 71 is simply an obvious extension of the pull up block of circuit 30 depicted in Fig. 3. To elementary pull down block 72' is associated its exact replication referenced 72'', which is mounted in parallel with it. The idea of duplicating twice or more, an elementary pull down block, within the pull down block 72, has extensive application, since it significantly improves the performance of the circuit, at the limited cost of a small increase in chip area.

At last it must also be understood that determining logic circuits of different nature, may be used while still remaining within the scope of the present invention. As an example, in the 2 input NAND circuit of Fig. 3, inverter C32 may be replaced by a NOR circuit, the resulting logic function corresponds to a NOR-NOT. The appropriate changes in the logic stack 34 do not represent any difficulty for the man skilled in the art.

Fig. 8 shows a comparison of the cross over current both in conventional and Multi Base Bi-CMOS 2 input NAND circuit of the present invention. Curves 80 and 81 respectively show the input and output signals.

At the transitions of the input signal, there appear peak currents in both the pull up and pull down blocks in the circuits. The currents in pull down blocks are referenced 82 and 83 respectively for the Multi Base and the prior art circuit. Similarly, the currents in the pull up blocks are referenced 84 and 85 respectively for the Multi Base and the prior art circuit. When the input goes from "low" to "high", the current peaks in the pull up blocks are referred to as the cross over currents. The cross over current is referenced 85a in the conventional circuit and 84a in the Multi Base circuit. Fig. 8 shows the drastic improvement due to the implementation of the concept of the present invention based on a Multi Base structure of the logic circuits.

## Claims

1. A logic circuit (20) providing a logic function F at its output terminal (23) comprising:
a pull up block (21) and a pull down block (22) connected in series between first and second voltage supplies (Vdd, GND) having an output node OUT coupled therebetween connected to said output terminal (23); wherein said pull down block comprises a logic circuit (24) connected in series between said output node OUT and a DOWN node DN; the latter node drives the base of a pull down transistor (T), whose collector and emitter are connected to said output node OUT and said second voltage supply, respectively; it further comprises a discharge device (Z) biased at a second reference voltage (Vref2) to control the discharge at said DOWN node DN; wherein said pull-up block (21) and said comprised logic circuit (24) includes input terminals adapted to receive logic input signals (A1, ...)
CHARACTERIZED IN THAT said pull up block (21) is comprised of n basic cells so called IEF, n being equal to or greater than 2ᵢ each cell IEFi (i= 1 to n) being implemented with a CMOS logic circuit (C1, ...) having at least one input terminal (IN1, ...) adapted to receive at least one of said logic input signals (A1, ...) and whose output drives the base of a NPN pull up transistor (T1, ...) connected in an emitter follower configuration; said CMOS logic circuit (C1, ...) being connected between said first voltage supply (Vdd) and a respective one of first reference voltages (Vref11, ...); all the collectors of said NPN pull up transistors (T1, ...) being connected to the said first voltage supply (Vdd) and all the emitters being dotted to said output node OUT together to perform the OR function on the logic functions determined by said CMOS logic circuits.

2. A logic circuit according to claim 1 wherein all the first reference voltages (Vref11 to Vref1n) are identical [Vref 11 = .... = Vref 1n = Vref1].

3. A logic circuit according to claim 1 or 2 wherein said CMOS logic circuits (C1, ...) are selected from the group of the elementary logic gates including: an inverter, a NOR and a NAND.

4. A logic circuit according to claim 3 wherein at least two CMOS logic circuits are different.

5. A logic circuit according to any above claims wherein at least two identical pull down blocks (72', 72'') are paralleled.

## Patentansprüche

1. Eine logische Schaltung (20), die an ihrem Ausgangsanschluß (23) eine logische Funktion F bereitstellt, enthaltend:
einen Pull-up-Block (21) und einen Pull-down-Block (22), die in Reihe zwischen ein erstes und ein zweites Versorgungsspannungspotential (Vdd, GND) geschaltet sind und einen dazwischenliegenden Ausgangsknoten OUT aufweisen, der mit dem Ausgangsanschluß (23) verbunden ist; wobei der Pull-down-Block eine logische Schaltung (24) enthält, die in Reihe zwischen dem Ausgangsknoten OUT und einem DOWN-Knoten DN liegt und letztgenannter Knoten einen Pull-down-Transistor (T) steuert, dessen Kollektor und Emitter mit besagtem Ausgangsknoten bzw. besagter Versorgungsspannung verbunden sind und der Pull-down-Block weiterhin ein Entladungselement (Z) enthält, das durch eine zweite Referenzspannung (Vref2) auf ein bestimmtes Spannungsniveau gelegt wird, um den Entladungsvorgang über den DOWN-Knoten DN zu steuern, wobei der Pull-up-Block (21) und die enthaltene logische Schaltung (24) Eingangsanschlüsse besitzen, die zum Empfang logischer Eingangssignale (A1, ...) angebracht sind
dadurch gekennzeichnet, daß der Pull-up-Block (21) n Grundbaugruppen enthält, die mit IEF bezeichnet werden, jede Baugruppe IEFi (i = 1 bis n) durch eine CMOS-Schaltung (C1, ...) implementiert, mindestens einen Eingangsanschluß (IN1, ...) besitzt, der zum Empfang mindestens eines logischen Eingangssignals (A1, ...) dient und dessen Ausgang die Basis eines in Emitterfolgerschaltung betriebenen npn-Pull-up-Transistors (T1, ...) ansteuert; die CMOS-Logikschaltung liegt in Reihe zwischen der ersten Versorgungsspannung (Vdd) und einer zugehörigen ersten Referenzspannung (Vref11, ...); alle Kollektoren der npn-Pull-up-Transistoren (T1, ...) sind mit der ersten Versorgungsspannung verbunden und alle Emitter sind mit dem Ausgangsknoten OUT verbunden, um eine ODER-Verknüpfung der logischen Funktionen, die durch die CMOS-Logikschaltungen bestimmt werden, zu realisieren.

2. Eine logische Schaltung gemäß Anspruch 1, wobei alle ersten Referenzspannungen (Vref11 bis Vref1n) identisch sind [V-ref11 = ... = Vref1n = Vref1].

3. Eine logische Schaltung gemäß Anspruch 1 oder 2, wobei besagte CMOS-Logikschaltungen (C1, ...) aus der Gruppe elementarer logischer Grundgatter ausgewählt werden, umfassend einen Inverter, ein NOR und ein NAND.

4. Eine logische Schaltung gemäß Anspruch 3, wobei mindestens zwei CMOS-Logikschaltungen unterschiedlich sind.

5. Eine logische Schaltung gemäß einem der obigen Ansprüche, wobei mindestens zwei identische Pull-down-Blöcke (72', 72'') parallelgeschaltet sind.

## Revendications

1. Circuit logique (20) délivrant une fonction logique F sur sa borne de sortie (23) comprenant:
un bloc (21) élévateur et un bloc (22) chuteur connectés en série entre des première et seconde alimentations en tension (Vdd, GND), ayant un noeud de sortie OUT couplé entre elles, relié à ladite borne de sortie (23); dans lequel ledit bloc chuteur comporte un circuit logique (24) connecté en série entre ledit noeud de sortie OUT et un noeud DOWH DN; le dernier noeud commande la base d'un transistor chuteur (T), dont le collecteur et l'émetteur sont connectés audit noeud de sortie OUT et à ladite seconde alimentation en tension, respectivement; il comporte en outre un dispositif de décharge (Z) polarisé à une seconde tension de référence (Vref2) pour commander la décharge audit noeud DOWN DN; dans lequel ledit bloc élévateur (21) et ledit circuit logique compris (24) comportent des bornes d'entrée adaptées pour recevoir des signaux d'entrée logiques (A1,...)
caractérisé en ce que ledit bloc élévateur (21) est constitué de n cellules de base appelées IEF, n étant égal ou supérieur à 2; chaque cellule IEFi (i=1 à n) étant mise en oeuvre avec un circuit logique CMOS (C1,...) ayant au moins une borne d'entrée (IN1,...) adaptée pour recevoir au moins l'un desdits signaux logiques d'entrée (A1,...), et dont la sortie commande la base d'un transistor élévateur NPN (T1,...) connecté dans une configuration à émetteur suiveur; ledit circuit logique CMOS (C1,...) étant connecté entre ladite première alimentation en tension (Vdd) et une tension respective parmi l'une des tensions de référence (Vref11,...); tous les collecteurs desdits transistors élévateurs NPN (T1,...) étant connectés à ladite première alimentation en tension (Vdd) et tous les émetteurs étant reliés ponctuellement audit noeud de sortie OUT, ensemble, pour effectuer la fonction OU sur les fonctions logiques déterminées par lesdits circuits logiques CMOS.

2. Circuit logique selon la revendication 1, dans lequel toutes les premières tensions de référence (Vref11 à Vref1n) sont identiques [Vref11 = ... = Vref1n = Vref1].

3. Circuit logique selon la revendication 1 ou 2, dans lequel lesdits circuits logiques CMOS (C1,...) sont sélectionnés à partir du groupe des portes logiques élémentaires comprenant: un inverseur, un circuit NON-OU et un circuit NON-ET.

4. Circuit logique selon la revendication 3, dans lequel au moins deux circuits logiques CMOS sont différents.

5. Circuit logique selon l'une quelconque des revendications précédentes, dans lequel au moins deux blocs chuteurs identiques (72' , 72'') sont mis en parallèle.
